(19) **Europäisches Patentamt / European Patent Office / Office européen des brevets**

(11) **EP 4 549 235 A1**

(12) # EUROPEAN PATENT APPLICATION

(43) Date of publication:
**07.05.2025 Bulletin 2025/19**

(21) Application number: **24200293.9**

(22) Date of filing: **13.09.2024**

(51) International Patent Classification (IPC):
**B60L 58/24** (2019.01)    **B60L 3/00** (2019.01)
**H01M 10/48** (2006.01)    **H01M 10/617** (2014.01)

(52) Cooperative Patent Classification (CPC):
**B60L 58/24; B60L 3/0046; H01M 10/486;
H01M 10/613; H01M 10/617; H01M 10/625;**
B60L 2240/545; B60L 2260/44; H01M 2220/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.11.2023 IN 202321075185**

(71) Applicant: **Tata Consultancy Services Limited
Maharashtra (IN)**

(72) Inventors:
• **RAMANUJAM, MURALIKRISHNAN
411057 Pune, Maharashtra (IN)**
• **RUNKANA, VENKATARAMANA
411013 Pune, Maharashtra (IN)**
• **VUPPULA, VIJAY KUMAR REDDY
411057 Pune, Maharashtra (IN)**

(74) Representative: **Goddar, Heinz J.
Boehmert & Boehmert
Anwaltspartnerschaft mbB
Pettenkoferstrasse 22
80336 München (DE)**

(54) **DETERMINING HEAT TRANSFER RATES BETWEEN BATTERY PACK AND COOLANT CHANNEL WITH VARYING COOLANT FLOW RATE**

(57) The disclosure relates generally to methods and systems for determining heat transfer rates between battery pack and coolant channel with varying coolant flow rate in a real-time. A lumped conductance generated between the battery pack and a coolant channel is used to determine the heat transfer rates between the battery pack and the coolant channel. Conventional techniques for calculating the lumped conductance between the battery and the coolant channel either use experimental methods or rely on the heat transfer correlations in simple geometry. The present disclosure calculates the lumped conductance by understanding an internal structure of a cylindrical battery pack using a high-fidelity computational fluid dynamic (CFD) simulation. This will help in determining the heat transfer rates of the battery pack in the real-time at the battery core especially when the coolant channel side hydrodynamic conditions change with time due to the variable coolant flow rates.

FIG. 11

EP 4 549 235 A1

# Description

CROSS-REFERENCE TO RELATED APPLICATIONS AND PRIORITY

The present application claims priority to Indian application no. 202321075185, filed on November 03, 2023.

TECHNICAL FIELD

The disclosure herein generally relates to battery monitoring, and, more particularly, to methods and systems for determining heat transfer rates between battery pack and coolant channel with varying coolant flow rate in real-time.

BACKGROUND

Electric vehicles (EV) and hybrid electric vehicles (HEV) are getting importance due to the pollution caused by fossil fuel vehicles and the need for clean energy sources in cities. The battery pack in the electric vehicle forms an important part (40% of the cost of the vehicles). A battery management system (BMS) performs the basic tasks of charging the battery pack in the vehicle and monitoring the important functions in the battery like current, voltage and temperature so that the battery does not catch fire (thermal runaway), undercharge or degrade soon.

With battery systems getting more common it is important to augment the capabilities of the BMS system by enhancing the life and the energy density in the battery. Current, voltage and temperature recorded in the battery pack could be used to understand more about the behavior of the battery and optimize the use of the pack to enhance energy efficiency there by decreasing the overall running costs and battery recycling costs. Digital twin is an efficient way to model the behavior of a real battery pack in a virtual environment and use the insights gained from the twin to optimize and predict future trends.

A typical digital twin inside an electric vehicle consists of modules to predict state of charge (SoC) and state of health (SoH) of the battery pack. The state of the health of a battery has a strong dependence on its temperature. The ideal operating range for the battery pack is between 25 C to 35 C. At higher temperatures above that limit, the capacity of the battery degrades faster and reduces the life of the battery. To meet the power requirements for an electric vehicle, several batteries are arranged in stack in series and parallel electrical connections. Since batteries generate heat during charging and discharging, the battery pack is cooled by air or liquid by forcing them to flow next to the batteries to maintain the temperature of the battery pack within the operating range. The heat generated by the batteries is transferred to the coolant and the type and the flow rate of coolant play an important role in maintaining the battery temperature.

Cooling battery packs with air is easier to design as air is readily available and the cost of the system is lower. But air has lower thermal capacity (density*specific heat) and so the volumetric flow rate of air required to cool battery pack in an electric vehicle needs to be much higher and provides design challenges for pumps to be used for efficient thermal management. Liquid coolants (water and ethylene glycol) that have high thermal capacity with varying coolant flow rates are preferred for cooling electric vehicle battery packs.

A lumped conductance model generated between the battery pack and a coolant channel is used to determine the heat transfer rates between the battery pack and the coolant channel with varying coolant flow rate in a real-time. However, conventional techniques for calculating the lumped conductance between the battery and the coolant channel either use experimental methods or rely on the heat transfer correlations in simple geometry. In cases where the cylindrical batteries are present, the heat transfer occurs partially over a surface of the battery pack due to a partial overlap with the coolant channel due to the battery curvature. In most of the available designs of the battery packs, the cooling channel exchanges the heat with either right or the left side of the battery pack. This makes the temperature distribution inside the battery asymmetric. The value of the lumped conductance calculated from experiments will change based on the hydrodynamics conditions inside in the fluid side of the channel and needs to be obtained a priori in lab conditions.

SUMMARY

Embodiments of the present disclosure present technological improvements as solutions to one or more of the above-mentioned technical problems recognized by the inventors in conventional systems.

In an aspect, a processor-implemented method for determining heat transfer rates between battery pack and coolant channel with varying coolant flow rate is provided. The method including the steps of: obtaining a plurality of battery data as an input, wherein the plurality of battery data comprises a temperature at one or more predefined locations of a battery pack comprising one or more batteries surrounding with an elastomer assembly, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack, wherein the battery pack is deployed in the electric vehicle; preprocessing the plurality of battery data to generate a pre-processed data, using one or more data pre-processing technique; determining a heat transfer rate between the coolant channel and the battery pack in real-time, wherein one or more coolant channel side hydrodynamic conditions change with time due to variable coolant flow rates, wherein determining the heat transfer rate between the coolant channel and the battery pack comprises: determining a lumped conductance data of the battery pack, for different predefined heat transfer coefficient values of the coolant channel, using a computational fluid dynamics (CFD) technique; collecting a preliminary temperature distribution across the battery pack, from the pre-processed data, based on the initial temperature of the battery pack; determining a current heat transfer coefficient value of the coolant channel, based on (i) a current coolant flow rate of the coolant channel, and (ii) a distance between each coolant channel battery intersection and the inlet of the coolant channel, for each of one or more coolant battery intersections; determining a current lumped conductance data of each battery of the one or more batteries present in the battery pack, based on the current heat transfer coefficient value of the coolant channel associated to each coolant channel battery intersection, from the lumped conductance data of the battery pack; and determining the heat transfer rate between the coolant channel and the battery pack in the real-time, based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack; and predicting a current temperature distribution inside the battery pack, based on the heat transfer rate between the coolant channel and the battery pack, using the variable coolant flow rate data of the coolant channel.

In another aspect, a system for determining heat transfer rates between battery pack and coolant channel with varying coolant flow rate is provided. The system includes: a memory storing instructions; one or more Input/Output (I/O) interfaces; and one or more hardware processors coupled to the memory via the one or more I/O interfaces, wherein the one or more hardware processors are configured by the instructions to: obtain a plurality of battery data as an input, wherein the plurality of battery data comprises a temperature at one or more predefined locations of a battery pack comprising one or more batteries surrounding with an elastomer assembly, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack, wherein the battery pack is deployed in the electric vehicle; preprocess the plurality of battery data to generate a pre-processed data, using one or more data pre-processing techniques; determine a heat transfer rate between the coolant channel and the battery pack in real-time, wherein one or more coolant channel side hydrodynamic conditions change with time due to variable coolant flow rates, wherein determining the heat transfer rate between the coolant channel and the battery pack comprises: determining a lumped conductance data of the battery pack, for different predefined heat transfer coefficient values of the coolant channel, using a computational fluid dynamics (CFD) technique; collecting a preliminary temperature distribution across the battery pack, from the pre-processed data, based on the initial temperature of the battery pack; determining a current heat transfer coefficient value of the coolant channel, based on (i) a current coolant flow rate of the coolant channel, and (ii) a distance between each coolant channel battery intersection and the inlet of the coolant channel, for each of one or more coolant battery intersections; determining a current lumped conductance data of each battery of the one or more batteries present in the battery pack, based on the current heat transfer coefficient value of the coolant channel associated to each coolant channel battery intersection, from the lumped conductance data of the battery pack; and determining the heat transfer rate between the coolant channel and the battery pack in the real-time, based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack; and predict a current temperature distribution inside the battery pack, based on the heat transfer rate between the coolant channel and the battery pack, using the variable coolant flow rate data of the coolant channel.

In yet another aspect, there are provided one or more non-transitory machine-readable information storage mediums comprising one or more instructions which when executed by one or more hardware processors cause: obtaining a plurality of battery data as an input, wherein the plurality of battery data comprises a temperature at one or more predefined locations of a battery pack comprising one or more batteries surrounding with an elastomer assembly, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack, wherein the battery pack is deployed in the electric vehicle; preprocessing the plurality of battery data to generate a preprocessed data, using one or more data pre-processing techniques; determining a heat transfer rate between the coolant channel and the battery pack in real-time, wherein one or more coolant channel side hydrodynamic conditions change with time due to variable coolant flow rates, wherein determining the heat transfer rate between the coolant channel and the battery pack comprises: determining a lumped conductance data of the battery pack, for different predefined heat transfer coefficient values of the coolant channel, using a computational fluid dynamics (CFD) technique; collecting a preliminary temperature distribution across the battery pack, from the pre-processed data, based on the initial temperature of the battery pack; determining a current heat transfer coefficient value of the coolant channel, based on (i) a current coolant flow rate of the coolant channel, and (ii) a distance between each coolant channel battery intersection and the inlet of the coolant channel, for each of one or more coolant battery intersections; determining a current lumped conductance data of each battery of the one or more batteries present in the battery pack, based on the current heat transfer coefficient value of the coolant channel associated to each coolant channel battery intersection, from the lumped conductance data of the battery pack; and determining the heat transfer rate between the coolant channel and the battery pack in the real-time, based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack; and predicting a current temperature distribution inside the battery pack, based on the heat transfer rate between the coolant channel and the battery pack, using the variable coolant flow rate data of the coolant channel.

In an embodiment, determining the lumped conductance data of the battery pack, for different predefined heat transfer coefficient values of the coolant channel, using the computational fluid dynamics (CFD) technique, comprising: receiving one or more dimensions of each battery of the one or more batteries of the battery pack, and one or more dimensions of the elastomer assembly attached to each battery; receiving one or more thermal parameters comprising: (i) a tangential thermal conductivity and a radial thermal conductivity of each battery, (ii) a thermal conductivity of the elastomer assembly attached to each battery, (iii) a specific heat capacity of each battery and the associated elastomer assembly, and (iv) a density of each battery and the associated elastomer assembly; creating a mesh of each battery of the one or more batteries and the mesh of the elastomer assembly attached to each battery, based on a geometry of each battery and the elastomer assembly attached to each battery, using a computer engineering software, wherein the geometry of each battery and the elastomer assembly attached to each battery is created using the one or more thermal parameters, and one or more dimensions of each battery of the one or more batteries of the battery pack, and one or more dimensions of the elastomer assembly; and determining the lumped conductance data of the battery pack, for different predefined heat transfer coefficient values of the coolant channel, for different heat generation rates, by assigning one or more boundary conditions and running several test cases on the mesh of each battery of the one or more batteries and the mesh of the elastomer assembly attached to each battery, using the computational fluid dynamics (CFD) technique.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 is an exemplary block diagram of a system for determining heat transfer rates between battery pack and coolant channel with varying coolant flow rate, in accordance with some embodiments of the present disclosure.

FIGS. 2A-2B illustrate exemplary flow diagrams of a processor-implemented method for determining heat transfer rates between battery pack and coolant channel with varying coolant flow rate, using the system of FIG. 1, in accordance with some embodiments of the present disclosure.

FIG. 3 shows an exemplary structure of a A123 cylindrical battery used in an electrical vehicle, in accordance with some embodiments of the present disclosure.

FIG. 4 shows a typical configuration of a battery pack with a cooling channel, according to some embodiments of the present disclosure.

FIG. 5 is s drawing showing how the battery exchanges heat with the coolant channel through the elastomer assembly, according to some embodiments of the present disclosure.

FIG. 6 is a flow chart illustrating the steps for determining a lumped conductance data of the battery pack, for different predefined heat transfer coefficient values of the coolant channel, using a computational fluid dynamics (CFD) technique, in accordance with some embodiments of the present disclosure.

FIG. 7A shows an exemplary implementation, using the system of FIG. 1, in accordance with some embodiments of the present disclosure.

FIG. 7B shows exemplary sub-systems of a battery digital twin of the exemplary implementation of FIG. 7A, using the system of FIG. 1, in accordance with some embodiments of the present disclosure.

FIG. 8 shows geometry for elastomer runs, view of 3-dimensional (3-D) mesh and 2-dimensional (2-D) cross-section of mesh, and magnified view of 2-D for the elastomer battery assembly to obtain the lumped conductance, in accordance with some embodiments of the present disclosure.

FIG. 9 shows temperature contours in the battery and elastomer assembly for a given heat source and wall heat transfer coefficient, in accordance with some embodiments of the present disclosure.

FIG. 10 is a graph showing how the lumped conductance change as a function of a heat transfer coefficient for different heat sources, in accordance with some embodiments of the present disclosure.

FIG. 11 is a graph showing how the lumped conductance change with respect to change in the heat source as a function of time, in accordance with some embodiments of the present disclosure.

DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Lithium-ion batteries are an important component of electric vehicles or energy storage systems. In electric vehicles, several batteries are assembled in a module to generate the required power and energy. While operating battery packs, thermal management is essential as batteries generate heat during charging and discharging. The high or low temperatures affect battery life and efficiency. Liquid coolants (water and ethylene glycol) that have high thermal capacity with varying coolant flow rates are preferred for cooling electric vehicle battery packs.

A lumped conductance generated between the battery pack and a coolant channel is used to determine the heat transfer rates between the battery pack and the coolant channel with varying coolant flow rate in real-time. However, conventional techniques for calculating the lumped conductance between the battery and the coolant channel either uses experimental methods or rely on the heat transfer correlations in simple geometry. In cases where the cylindrical batteries are present, the heat transfer occurs partially over a surface of the battery pack due to a partial overlap with the coolant channel due to the battery curvature. In most of the available designs of the battery packs, the cooling channel exchanges the heat with either right or the left side of the battery pack. This makes the temperature distribution inside the battery asymmetric. The value of the lumped conductance calculated from experiments will change based on the hydrodynamics conditions inside in the fluid side of the channel and needs to be obtained a priori in lab conditions.

The present disclosure solves the technical problems in the art with the methods and systems for determining heat transfer rates between battery pack and coolant channel with varying coolant flow rate. The present disclosure enhances the accuracy of the thermal model in a battery stack cooled by the coolant channel on one side of a cylindrical battery pack by understanding an internal structure of a cylindrical battery pack using a high-fidelity computational fluid dynamic (CFD) simulation. The present disclosure also builds an expression for the lumped conductance as a function of the coolant side varying flow rates over which the lumped conductance depends upon. This will help in determining the heat transfer rates of the battery pack in the real-time at the battery core especially when the coolant channel side hydrodynamic conditions change with time due to the variable coolant flow rates.

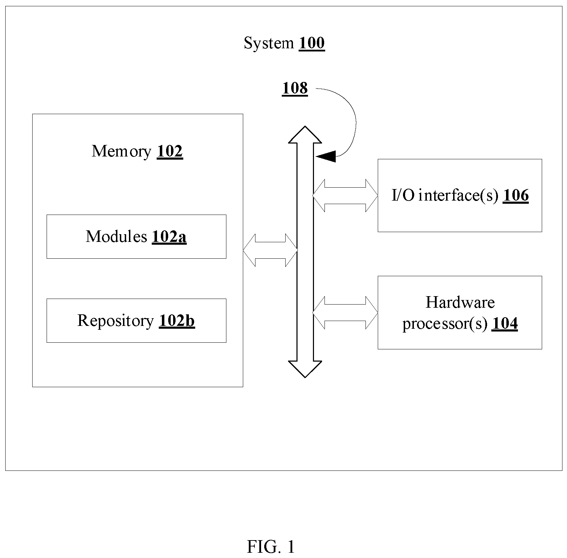

Referring now to the drawings, and more particularly to FIG. 1 through FIG. 11, where similar reference characters denote corresponding features consistently throughout the figures, there are shown preferred embodiments and these embodiments are described in the context of the following exemplary system and/or method.

FIG. 1 is an exemplary block diagram of a system 100 for determining heat transfer rates between battery pack and coolant channel with varying coolant flow rate, in accordance with some embodiments of the present disclosure. In an embodiment, the system 100 includes or is otherwise in communication with one or more hardware processors 104, communication interface device(s) or input/output (I/O) interface(s) 106, and one or more data storage devices or memory 102 operatively coupled to the one or more hardware processors 104. The one or more hardware processors 104, the memory 102, and the I/O interface(s) 106 may be coupled to a system bus 108 or a similar mechanism.

The I/O interface(s) 106 may include a variety of software and hardware interfaces, for example, a web interface, a graphical user interface (GUI), and the like. The I/O interface(s) 106 may include a variety of software and hardware interfaces, for example, interfaces for peripheral device(s), such as a keyboard, a mouse, an external memory, a plurality of sensor devices, a printer and the like. Further, the I/O interface(s) 106 may enable the system 100 to communicate with other devices, such as web servers and external databases.

The I/O interface(s) 106 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 106 may include one or more ports for connecting a number of computing systems with one another or to another server computer. Further, the I/O interface(s) 106 may include one or more ports for connecting a number of devices to one another or to another server.

The one or more hardware processors 104 may be implemented as one or more microprocessors, microcomputers, microcontrollers, digital signal processors, central processing units, state machines, logic circuitries, and/or any devices that manipulate signals based on operational instructions. Among other capabilities, the one or more hardware processors 104 are configured to fetch and execute computer-readable instructions stored in the memory 102. In the context of the present disclosure, the expressions 'processors' and 'hardware processors' may be used interchangeably. In an embodiment, the system 100 can be implemented in a variety of computing systems, such as laptop computers, portable computers, notebooks, hand-held devices, workstations, mainframe computers, servers, a network cloud and the like.

The memory 102 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment, the memory 102 includes a plurality of modules 102a and a repository 102b for storing data processed, received, and generated by one or more of the plurality of modules 102a. The plurality of modules 102a may include routines, programs, objects, components, data structures, and so on, which perform particular tasks or implement particular abstract data types.

The plurality of modules 102a may include programs or computer-readable instructions or coded instructions that supplement applications or functions performed by the system 100. The plurality of modules 102a may also be used as, signal processor(s), state machine(s), logic circuitries, and/or any other device or component that manipulates signals based on operational instructions. Further, the plurality of modules 102a can be used by hardware, by computer-readable instructions executed by the one or more hardware processors 104, or by a combination thereof. In an embodiment, the plurality of modules 102a can include various sub-modules (not shown in FIG. 1). Further, the memory 102 may include information pertaining to input(s)/output(s) of each step performed by the processor(s) 104 of the system 100 and methods of the present disclosure.

The repository 102b may include a database or a data engine. Further, the repository 102b amongst other things, may serve as a database or includes a plurality of databases for storing the data that is processed, received, or generated as a result of the execution of the plurality of modules 102a. Although the repository 102b is shown internal to the system 100, it will be noted that, in alternate embodiments, the repository 102b can also be implemented external to the system 100, where the repository 102b may be stored within an external database (not shown in FIG. 1) communicatively coupled to the system 100. The data contained within such external database may be periodically updated. For example, data may be added into the external database and/or existing data may be modified and/or non-useful data may be deleted from the external database. In one example, the data may be stored in an external system, such as a Lightweight Directory Access Protocol (LDAP) directory and a Relational Database Management System (RDBMS). In another embodiment, the data stored in the repository 102b may be distributed between the system 100 and the external database.

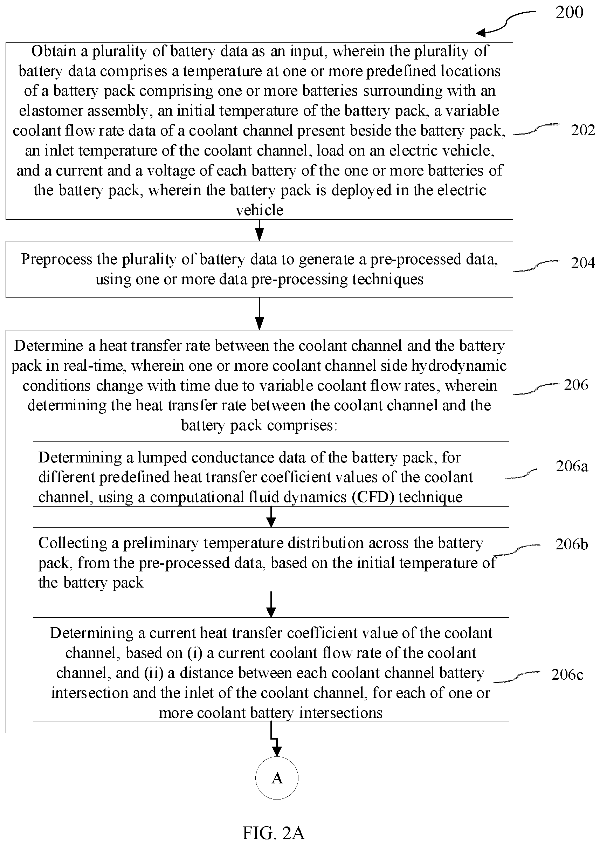

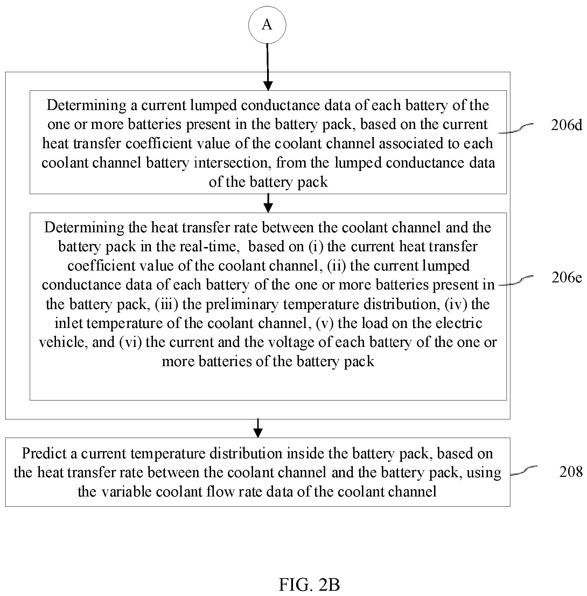

Referring to FIGS. 2A-2B, components and functionalities of the system 100 are described in accordance with an example embodiment of the present disclosure. For example, FIGS. 2A-2B illustrate exemplary flow diagrams of a processor-implemented method 200 for determining heat transfer rates between battery pack and coolant channel with varying coolant flow rate, using the system of FIG. 1, in accordance with some embodiments of the present disclosure. Although the steps of the method 200 shown in FIGS. 2A-2B including process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

At step 202 of the method 200, the one or more hardware processors 104 of the system 100 are configured to obtain a plurality of battery data as input. The plurality of battery data includes a temperature at one or more predefined locations of a battery pack, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack.

In an embodiment, the battery pack includes one or more batteries arranged in a stack and surrounded with an elastomer assembly. In an embodiment, the one or more batteries are cylindrical in shape with same dimensions or the geometry and with same or different battery capacities. In the embodiment of the present disclosure, the battery pack is deployed in the electric vehicle. In an embodiment, the plurality of battery data is obtained as a time-series data with a predefined interval.

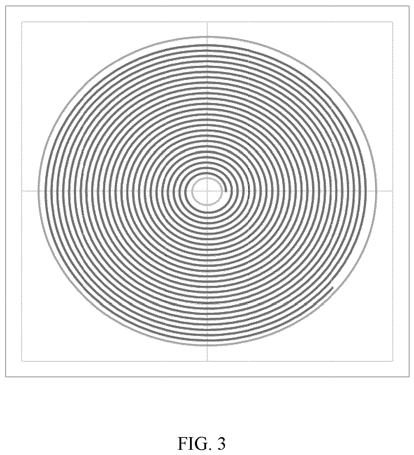

FIG. 3 shows an exemplary structure of a A123 cylindrical battery used in an electrical vehicle, in accordance with some embodiments of the present disclosure. As shown in FIG. 3, the spiral part of the picture is the jelly roll where the anode, cathode, and electrolyte are put together as a sheet and rolled inside a cylindrical outer casing. The void of the battery is also shown at the center.

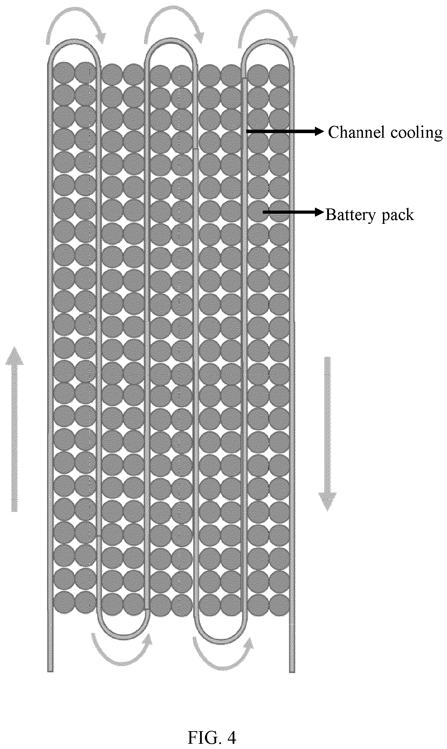

Since conductive liquid coolants like water can short the battery when it comes into contact with the electrical leads, the coolant is pumped inside a thermally conductive channel and the channel is kept in proximity with the battery stack. FIG. 4 shows a typical configuration of a battery pack with a cooling channel, according to some embodiments of the present disclosure.

As shown in FIG. 4, the batteries exchange heat with the coolant channel flow in a tube that is flowing from the inlet (left bottom). The coolant channel moves flows through a set of battery rows in a forward direction and then reverses in direction and exchanges heat with a next set of battery stack. The bends repeat itself until the coolant reaches the outlet (bottom right). This serpentine configuration helps in saving space and at the same time reduces the piping by requiring just one inlet and outlet for the entire battery stack.

By the design of the configuration, the coolant entering the inlet would have the lowest temperature and as the battery exchanges heat with the coolant, the temperature of the coolant increases downstream from the inlet. To calculate the battery temperatures as the system is operational the heat transfer rate between the battery and the coolant needs to be calculated accurately. As can see from the arrangement the battery exchanges heat with the coolant channel just on one side of the flow assembly. For example, in the channel downstream of the inlet the battery stack on the right exchanges heat with it, while that battery stack is isolated on the right side.

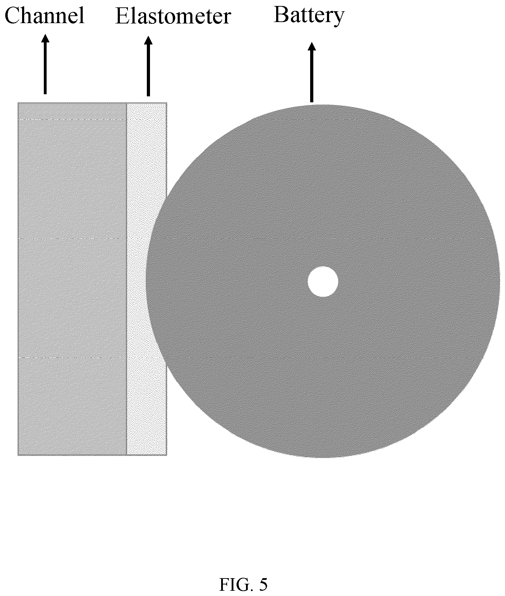

FIG. 5 is s drawing showing how the battery exchanges heat with the coolant channel through the elastomer assembly, according to some embodiments of the present disclosure. As shown in FIG. 5, the battery is the dark ash region on the right, the light ash region is the channel through which coolant flows and the whitish region (middle region) is the elastomer which is an electric insulator but a thermally conductive material to transfer just the heat from the battery to the coolant channel. As it can be seen only a fraction of the battery surface is in touch with the elastomer assembly. The arrangement repeats itself for other batteries as shown the earlier picture of the stack. For modeling the entire battery stack-coolant assembly, the heat generation within the battery, the heat transfer between the battery core to the coolant channel surface and from coolant channel surface to the coolant liquid flowing in the channel needs to be calculated.

At step 204 of the method 200, the one or more hardware processors 104 of the system 100 are configured to preprocess the plurality of battery data obtained at step 202 of the method 200, to generate a pre-processed data. In an embodiment, one or more data pre-processing techniques are employed on the plurality of battery data to generate the pre-processed data. The one or more data pre-processing techniques are conditioned on the plurality of battery data (the time-series data) to perform data processing steps including but are not limited to filling missing data, removal of outliers, data normalization, and data formatting, to facilitate for further processing.

At step 206 of the method 200, the one or more hardware processors 104 of the system 100 are configured to determine a heat transfer rate between the coolant channel and the battery pack in a real-time. The heat transfer rate between the coolant channel and the battery pack in the real-time is determined especially when the one or more coolant channel side hydrodynamic conditions change with time due to the variable coolant flow rates. Determining the heat transfer rate between the coolant channel and the battery pack in the real-time is further explained through steps 206a through 206e.

At step 206a, a lumped conductance data of the battery pack is determined for different predefined heat transfer coefficient values of the coolant channel. A computational fluid dynamics (CFD) technique is employed to determine the lumped conductance data of the battery pack for different predefined heat transfer coefficient values of the coolant channel, considering the geometry of the battery pack.

To understand the heat transfer from the battery to the elastomer surface next to the coolant (fluid), the high-fidelity computational fluid dynamics (CFD) can be used as it provides accurate picture of the temperature field inside the battery elastomer assembly. Since heat transfer is asymmetric with the battery surface, the temperature field inside the battery will be asymmetric too and hence standard correlations available for calculating net conductance will not work. Hence CFD is tool to calculate the conductance is desirable.

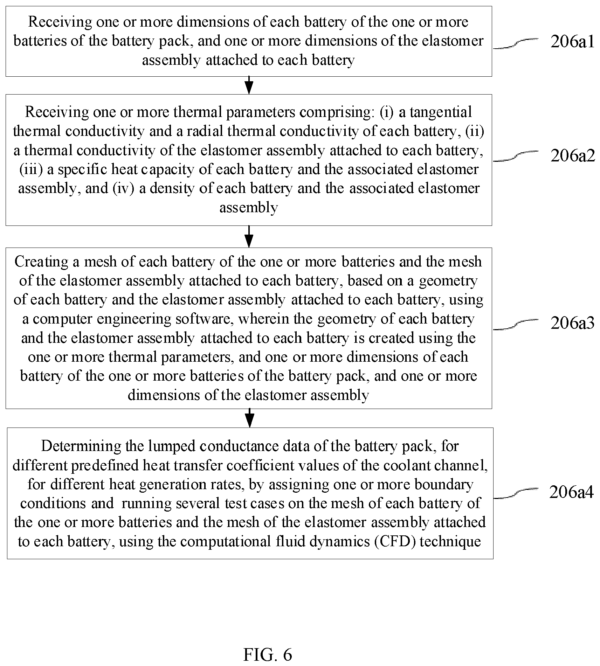

FIG. 6 is a flow chart illustrating the steps for determining a lumped conductance data of the battery pack, for different predefined heat transfer coefficient values of the coolant channel, using a computational fluid dynamics (CFD) technique, in accordance with some embodiments of the present disclosure. As shown in FIG. 6, determining the lumped conductance data of the battery pack, for different predefined heat transfer coefficient values of the coolant channel is further explained through steps 206a1 through 206a4.

At step 206a1, one or more dimensions of each battery of the one or more batteries of the battery pack, and one or more dimensions of the elastomer assembly attached to each battery are received. In an embodiment, the one or more dimensions of each battery include a battery length and a battery diameter. In an embodiment, the one or more dimensions of the elastomer assembly includes a strip width, a thinness of the strip, and a length of the step.

A described earlier, if the shape or geometry of each battery present in the battery pack is same, then the one or more dimensions of one such battery is sufficient. Otherwise, the one or more dimensions of each such battery that has different shape, or the different battery are received. The total curved circumference of the battery that is in contact with the elastomer assembly of its total side surface area is considered in the geometry of each battery.

At step 206a2, one or more thermal parameters of each battery of the one or more batteries present in the battery pack are received. In an embodiment, the one or more thermal parameters include (i) a tangential thermal conductivity and a radial thermal conductivity of each battery, (ii) a thermal conductivity of the elastomer assembly attached to each battery, (iii) a specific heat capacity of each battery and the elastomer assembly attached to each battery, and (iv) a density of each battery and the elastomer assembly attached to each battery.

At step 206a3, a mesh of each battery of the one or more batteries and the mesh of the elastomer assembly attached to each battery, are created, based on a geometry of each battery and the elastomer assembly attached to each battery, using a computer engineering software. The geometry of each battery and the elastomer assembly attached to each battery is created using the one or more thermal parameters, and one or more dimensions of each battery of the one or more batteries of the battery pack, and one or more dimensions of the elastomer assembly, received in previous steps.

At step 206a4, the lumped conductance data of the battery pack, is determined for different predefined heat transfer coefficient values of the coolant channel, for different heat generation rates, by running several test cases on the mesh of each battery of the one or more batteries and the mesh of the elastomer assembly attached to each battery, using the computational fluid dynamics (CFD) technique.

Firstly, the material properties of the battery and the material properties of the elastomer assembly are set up, and the boundary condition is set up as convective boundary condition on the elastomer assembly wall with a heat transfer coefficient and a specified ambient temperature, wherein the material properties of the battery. Then, all other walls are set as adiabatic (zero heat flux) wall and the heat source for the battery is set up. Lastly, several cases are run to calculate the lumped conductance for different heat sources and convective heat transfer coefficient on the elastomer coolant channel wall.

Simulations were performed for different assumed constant sources of energy in the battery and different assumed heat transfer coefficients at the coolant wall-elastomer interface. The effective heat transfer conductance $k_{lumped}$ is calculated using the formula:

$$ k_{lumped} = \frac{h_{conv}A\left(T_{sur_{avg}} - T_{fluid}\right)}{\left(T_{battery_{max}} - T_{sur_{avg}}\right)} $$

Where, A is the surface of the elastomer, $T_{sur_{avg}}$ is the area average temperature on the elastomer surface, $T_{fluid}$ is the assumed fluid temperature, $T_{battery_{max}}$ is the maximum temperature of the battery measured during the simulation, $h_{conv}$ is the assumed heat transfer coefficient on the coolant side. The heat source is varied in different ranges.

At step 206b, a preliminary temperature distribution across the battery pack, from the pre-processed data, is collected, based on the initial temperature of the battery pack. In an embodiment, the information on the preliminary temperature distribution across the battery pack is collected from a historical information with respect to the initial temperature of the battery pack. In an embodiment, information with respect to the preliminary temperature distribution across the battery pack (and one or more related parameters) associated with a certain past time instances of time are collected and stored as the historical information.

At step 206c, a current heat transfer coefficient value of the coolant channel is determined based on (i) a current coolant flow rate of the coolant channel, and (ii) a distance between each coolant channel battery intersection and the inlet of the coolant channel, for each of one or more coolant battery intersections.

At step 206d, a current lumped conductance data of each battery of the one or more batteries present in the battery pack, is determined based on the current heat transfer coefficient value of the coolant channel associated to each coolant channel battery intersection, from the lumped conductance data of the battery pack.

At step 206e, the heat transfer rate between the coolant channel and the battery pack in the real-time, is determined based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack.

At the start of the simulation the battery stack iniital temperatures, coolant temperatures and flow rates are provided. The simulation proceeds by marching in time starting from the first battery in the system close to the inlet. With initially provided values of heat transfer coefficient and the temperatures, the energy conservation equations descirbed above are solved for the battery and the elastomer for a given heat flux generation provided to the battery and lumped condutance calculated based on fluid side heat transfer coefficient for the battery-ealstomer assembly. The elastomer temperature determined is assumed to be close to the surface temperature of the coolant surface.

If the changes in the flow rates on the coolant side is small, then the constant lumped conductance obtained from the CFD for heat transfer coefficient by using the coolant flow rate averaged over time for the entire simulation. At step 208 of the method 200, the one or more hardware processors 104 of the system 100 are configured to predict a current temperature distribution inside the battery pack, based on the heat transfer rate between the coolant channel and the battery pack, using the variable coolant flow rate data of the coolant channel.

The methods and systems of the present disclosure calculates the lumped conductance between the battery pack and the coolant channel, by understanding an internal structure of a cylindrical battery pack using a high-fidelity computational fluid dynamic (CFD) simulation. Hence the heat transfer rates of the battery pack are effectively and efficiently determined in the real-time, at the battery core especially when the one or more coolant channel side hydrodynamic conditions change with time due to the variable coolant flow rates.

Example scenario:

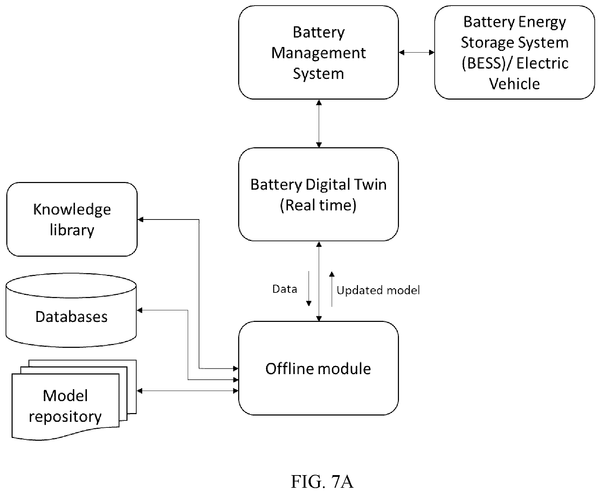

FIG. 7A shows an exemplary implementation, using the system 100 of FIG. 1, in accordance with some embodiments of the present disclosure. The exemplary implementation in FIG. 7A showcases various components of the system 100 that consist of both hardware and software. The system 100 as in FIG. 7A includes an on-premises Battery Digital Twin (BDT) linked to Battery Management System (BMS) associated with either a Battery Energy Storage System (BESS) or the battery pack in the Electric Vehicle (EV) and an Offline module. The BDT acquires data from the BESS/EV pack via the BMS and provides real time recommendation to achieve optimal performance. The data may include information related to voltage, current, surface temperature, resting period, etc., obtained from sensors/ Supervisory Control and Data Acquisition (SCADA)/ Distributed Control System (DCS) associated with EV/BESS. The BDT utilizes computationally lightweight models to provide real time recommendation to the BMS. These models are periodically updated through the Offline module. The Offline module uses customized physics-based models or PBM of cells used in BESS/EV to simulate the performance of cell at different operating conditions. The simulated data obtained from PBM model along with the pre-processed data from the BDT is used by the Data Analytics Platform (e.g., TCS InTwin™) to build or update computationally light weight models. These models can be either machine learning based models or reduced order models. The Offline module utilizes information from Knowledge Library, Databases and Model repository for building physics-based model as well as in a Data Analytics Platform. A Knowledge Library contains information regarding various parameters used for physics-based battery models that is obtained from literature, experiments, API, etc. Database on the other hand contains sensor data obtained from the BMS. A Model repository consists of various types of physics-based models that can be used for modeling different physical, chemical, electrochemical, thermal mechanisms inside a battery.

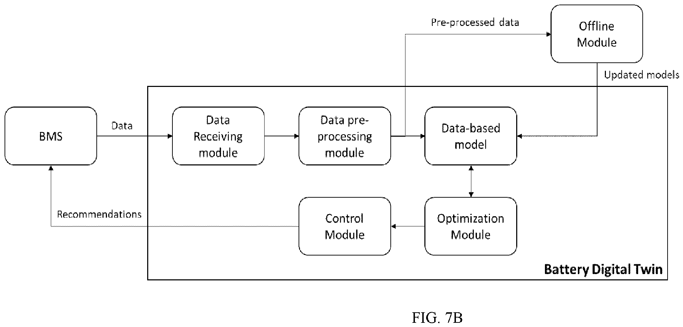

FIG. 7B shows exemplary sub-systems of a battery digital twin of the exemplary implementation of FIG. 7A, using the system 100 of FIG. 1, in accordance with some embodiments of the present disclosure. As shown in FIG. 7B, the BMS data is received by a Data Receiving module which then directs data towards a Data Pre-processing module. The data preprocessing involves detecting and eliminating outliers, filling in missing data, and harmonizing and incorporating multiple variables from one or more data origins. The data collected from different sources can be standardized, such as being uniformly sampled every minute. Real-time data is appropriately averaged, while non-real-time data is either interpolated or duplicated as needed. The pre-processed data is then directed to be used by the Data-based model to predict state variables such as State-of-Charge, State-of-health, etc. The Data-based models can be Reduced order models or machine learning models. The Data-based model is computationally inexpensive and can run in real time. This Data-based model is linked to the Optimization module that is used to determine optimal operating conditions to ensure longer cell life and safe operation. Based on the optimal conditions obtained from the optimization module, a control module provides feedback to the BMS. The Data-based model is updated periodically by the Offline Simulation module. As shown in FIG. 7B, the Offline simulation module receives the pre-processed data from the BDT. It then uses the data to build and update the Data-based model.

Further, the battery stack exchanges heat with the coolant channel through the elastomer coating. To obtain the heat transfer resistance due to elastomer, 3-D Fluent runs with elastomer and batteries are conducted. The battery is modeled as a cylinder based on the actual dimensions of the A123 cell. The elastomer is added as a strip of width 2.8 mm cut out in the center where the battery comes in contact. The minimum thickness of the strip is 1.4 mm. The length of the strip is the same as the battery diameter. The heat transfer to the coolant is modeled as a convective boundary condition in Fluent with an assumed heat transfer coefficient.

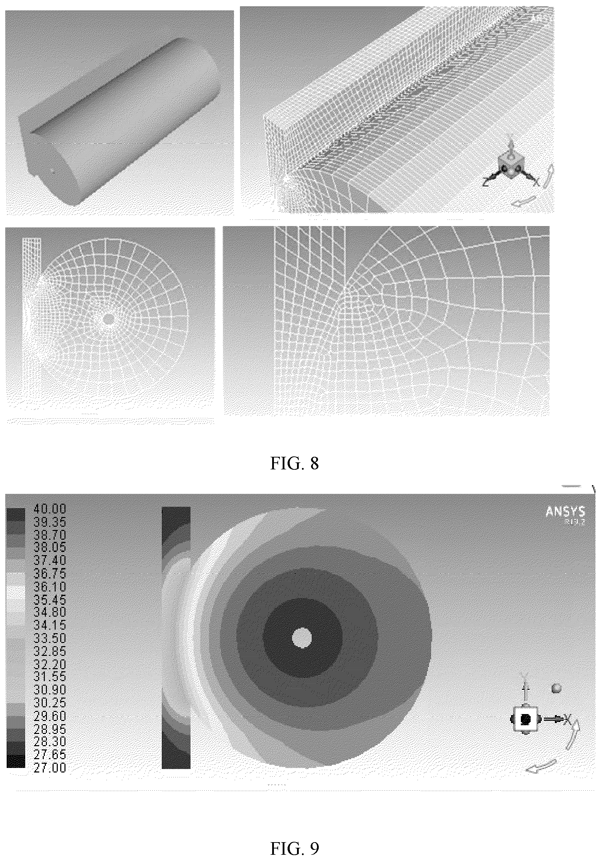

The total curved circumference of the battery in contact with the elastomer is 0.2 of its total side surface area. In the battery, a radial conductivity of 0.63 W/m2K and tangential conductivity of 14.6 W/m2K were used. The thermal conductivity of the elastomer is 1 W/m2K. A steel shell of 0.33 mm thickness and conductivity of 16.6 W/m2K is used. The shell is modeled using the shell conduction module in Fluent. FIG. 8 shows geometry for elastomer runs, view of 3-D mesh and 2-D cross-section of mesh, and magnified view of 2-D for the elastomer battery assembly to obtain the lumped conductance, in accordance with some embodiments of the present disclosure. The cross-section of the mesh is shown in FIG. 8. The total cell count for the Fluent run was around 150,000.

Simulations were performed for different assumed constant sources of energy in the battery and different assumed heat transfer coefficients at the coolant wall-elastomer interface. The steady-state temperature contour for a source of 50000 W/m$^3$ and convection heat transfer coefficient of 1400W/m$^2$K. FIG. 9 shows temperature contours in the battery and elastomer assembly for a given heat source and wall heat transfer coefficient, in accordance with some embodiments of the present disclosure. The effective heat transfer conductance $k_{lumped}$ is calculated using the same formula:

$$k_{lumped} = \frac{h_{conv}A\left(T_{sur_{avg}} - T_{fluid}\right)}{\left(T_{battery_{max}} - T_{sur_{avg}}\right)}$$

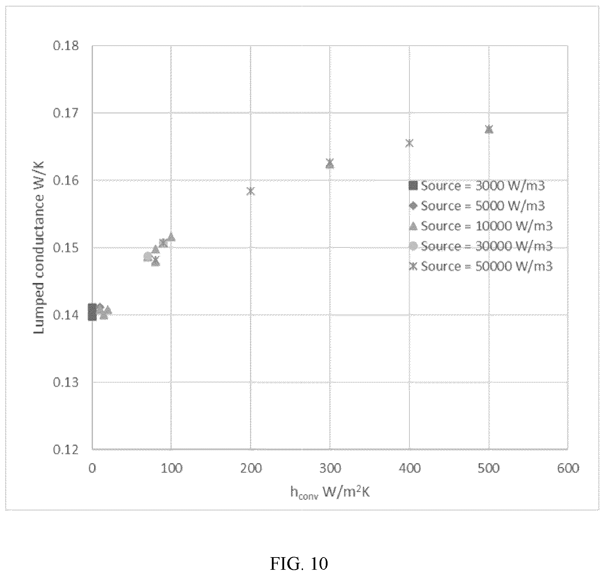

Here, A is the surface of the elastomer, $T_{sur_{avg}}$ is the area average temperature on the elastomer surface, $T_{fluid}$ is the assumed fluid temperature set as 300 K, $T_{battery_{max}}$ is the maximum temperature of the battery measured in the simulation, $h_{conv}$ is the assumed heat transfer coefficient on the coolant side. FIG. 10 is a graph showing how the lumped conductance change as a function of a heat transfer coefficient for different heat sources, in accordance with some embodiments of the present disclosure. As shown in FIG. 10, the heat source is varied between 3000-50000W/m$^3$ and $h_{conv}$ is between 10 to 500 W/m$^2$K.

The lumped conductance of the battery elastomer assembly derived at a steady state with an assumed heat transfer coefficient and a given heat source. Since the load is varying with time, the validity of the shape factor needs to be tested during unsteady runs. To check the lumped conductance change, in the heat source, simulations are conducted where the source is changed from 50,000 to 70,000 W/m3 after a steady state is achieved with 50,000 W/m3. The convection heat transfer coefficient on the channel is assumed to be 400 W/m2.

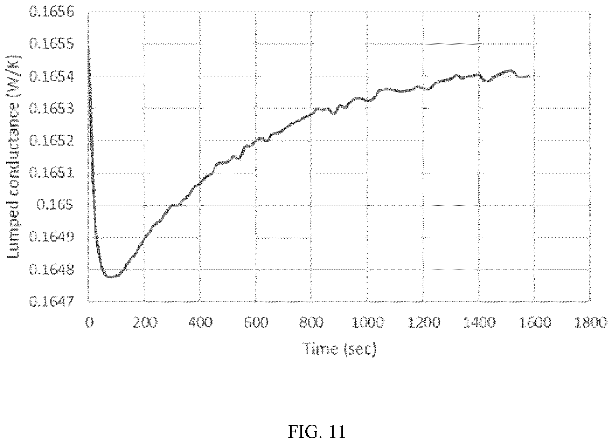

FIG. 11 is a graph showing how the lumped conductance change with respect to change in the heat source as a function of time, in accordance with some embodiments of the present disclosure. From FIG. 11, the results of values calculated with a step change in heat source are shown as a function of the time it takes to reach a steady state after the step change in source. As can be observed, the shape factor changes only the third decimal.

As observed, the lumped conductance changes during the load change are quite small. It is possible now to use the calculated lumped conductance along with its relationship with respect to fluid side hydrodynamic conditions along with the load profile in the battery to calculate the battery core temperature history as battery stack undergoes charge-discharge in the real-time. This methodology could be used for several battery elastomer dimensions and for wavy channel instead of a straight channel that carries the coolant.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problem of determining heat transfer rates between the battery pack and the coolant channel with the varying coolant flow rate in the real-time. The present disclosure enhances the accuracy of the thermal model in the battery stack cooled by the coolant channel on one side of the cylindrical battery pack by understanding the internal structure of the cylindrical battery pack using the high-fidelity computational fluid dynamic (CFD) simulation. The present disclosure also builds the expression for the lumped conductance as the function of the coolant side varying flow rates over which the lumped conductance depends upon. This will help in determining the heat transfer rates of the battery pack in the real-time at the battery core especially when the coolant channel side hydrodynamic conditions change with time due to the variable coolant flow rates.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

1. A processor implemented method (200), comprising:

   obtaining, via one or more hardware processors, a plurality of battery data as an input, wherein the plurality of battery data comprises a temperature at one or more predefined locations of a battery pack comprising one or more batteries surrounding with an elastomer assembly, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack, wherein the battery pack is deployed in the electric vehicle (202);

   preprocessing, via the one or more hardware processors, the plurality of battery data to generate a pre-processed data, using one or more data pre-processing techniques (204); and

   determining, via the one or more hardware processors, a heat transfer rate between the coolant channel and the battery pack in real-time, wherein one or more coolant channel side hydrodynamic conditions change with time due to variable coolant flow rates (206), wherein determining the heat transfer rate between the coolant channel and the battery pack comprises:

   determining a lumped conductance data of the battery pack, for different predefined heat transfer coefficient values of the coolant channel, using a computational fluid dynamics (CFD) technique (206a);

   collecting a preliminary temperature distribution across the battery pack, from the pre-processed data, based on the initial temperature of the battery pack (206b);

   determining a current heat transfer coefficient value of the coolant channel, based on (i) a current coolant flow rate of the coolant channel, and (ii) a distance between each coolant channel battery intersection and the inlet of the coolant channel, for each of one or more coolant battery intersections (206c);

   determining a current lumped conductance data of each battery of the one or more batteries present in the battery pack, based on the current heat transfer coefficient value of the coolant channel associated to each coolant channel battery intersection, from the lumped conductance data of the battery pack (206d); and

   determining the heat transfer rate between the coolant channel and the battery pack in the real-time, based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack (206e).

2. The processor implemented method as claimed in claim 1, further comprising predicting, via the one or more hardware processors, a current temperature distribution inside the battery pack, based on the heat transfer rate between the coolant channel and the battery pack, using the variable coolant flow rate data of the coolant channel (208).

3. The processor implemented method as claimed in claim 1, wherein determining the lumped conductance data of the battery pack, for different predefined heat transfer coefficient values of the coolant channel, using the computational fluid dynamics (CFD) technique, comprising:

receiving one or more dimensions of each battery of the one or more batteries of the battery pack, and one or more dimensions of the elastomer assembly attached to each battery (206a1);
receiving one or more thermal parameters comprising: (i) a tangential thermal conductivity and a radial thermal conductivity of each battery, (ii) a thermal conductivity of the elastomer assembly attached to each battery, (iii) a specific heat capacity of each battery and the associated elastomer assembly, and (iv) a density of each battery and the associated elastomer assembly (206a2);
creating a mesh of each battery of the one or more batteries and the mesh of the elastomer assembly attached to each battery, based on a geometry of each battery and the elastomer assembly attached to each battery, using a computer engineering software, wherein the geometry of each battery and the elastomer assembly attached to each battery is created using the one or more thermal parameters, and one or more dimensions of each battery of the one or more batteries of the battery pack, and one or more dimensions of the elastomer assembly (206a3); and
determining the lumped conductance data of the battery pack, for different predefined heat transfer coefficient values of the coolant channel, for different heat generation rates, by assigning one or more boundary conditions and running several test cases on the mesh of each battery of the one or more batteries and the mesh of the elastomer assembly attached to each battery, using the computational fluid dynamics (CFD) technique (206a4).

4. A system (100) comprising:

a memory (102) storing instructions;
one or more input/output (I/O) interfaces (106); and
one or more hardware processors (104) coupled to the memory (102) via the one or more I/O interfaces (106), wherein the one or more hardware processors (104) are configured by the instructions to:

obtain a plurality of battery data as an input, wherein the plurality of battery data comprises a temperature at one or more predefined locations of a battery pack comprising one or more batteries surrounding with an elastomer assembly, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack, wherein the battery pack is deployed in the electric vehicle;
preprocess the plurality of battery data to generate a pre-processed data, using one or more data pre-processing techniques; and
determine a heat transfer rate between the coolant channel and the battery pack in real-time, wherein one or more coolant channel side hydrodynamic conditions change with time due to variable coolant flow rates, wherein determining the heat transfer rate between the coolant channel and the battery pack comprises:

determining a lumped conductance data of the battery pack, for different predefined heat transfer coefficient values of the coolant channel, using a computational fluid dynamics (CFD) technique;
collecting a preliminary temperature distribution across the battery pack, from the pre-processed data, based on the initial temperature of the battery pack;
determining a current heat transfer coefficient value of the coolant channel, based on (i) a current coolant flow rate of the coolant channel, and (ii) a distance between each coolant channel battery intersection and the inlet of the coolant channel, for each of one or more coolant battery intersections;
determining a current lumped conductance data of each battery of the one or more batteries present in the battery pack, based on the current heat transfer coefficient value of the coolant channel associated to each coolant channel battery intersection, from the lumped conductance data of the battery pack; and
determining the heat transfer rate between the coolant channel and the battery pack in the real-time, based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack.

5. The system as claimed in claim 4, wherein the one or more hardware processors (104) are further configured to predict a current temperature distribution inside the battery pack, based on the heat transfer rate between the coolant channel and the battery pack, using the variable coolant flow rate data of the coolant channel.

6. The system as claimed in claim 4, wherein the one or more hardware processors (104) are configured to determine the lumped conductance data of the battery pack, for different predefined heat transfer coefficient values of the coolant channel, using the computational fluid dynamics (CFD) technique, by:

receiving one or more dimensions of each battery of the one or more batteries of the battery pack, and one or more dimensions of the elastomer assembly attached to each battery;
receiving one or more thermal parameters comprising: (i) a tangential thermal conductivity and a radial thermal conductivity of each battery, (ii) a thermal conductivity of the elastomer assembly attached to each battery, (iii) a specific heat capacity of each battery and the associated elastomer assembly, and (iv) a density of each battery and the associated elastomer assembly;
creating a mesh of each battery of the one or more batteries and the mesh of the elastomer assembly attached to each battery, based on a geometry of each battery and the elastomer assembly attached to each battery, using a computer engineering software, wherein the geometry of each battery and the elastomer assembly attached to each battery is created using the one or more thermal parameters, and one or more dimensions of each battery of the one or more batteries of the battery pack, and one or more dimensions of the elastomer assembly; and
determining the lumped conductance data of the battery pack, for different predefined heat transfer coefficient values of the coolant channel, for different heat generation rates, by assigning one or more boundary conditions and running several test cases on the mesh of each battery of the one or more batteries and the mesh of the elastomer assembly attached to each battery, using the computational fluid dynamics (CFD) technique.

7. One or more non-transitory machine-readable information storage mediums comprising one or more instructions which when executed by one or more hardware processors cause:

obtaining a plurality of battery data as an input, wherein the plurality of battery data comprises a temperature at one or more predefined locations of a battery pack comprising one or more batteries surrounding with an elastomer assembly, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack, wherein the battery pack is deployed in the electric vehicle;
preprocessing the plurality of battery data to generate a pre-processed data, using one or more data pre-processing techniques; and
determining a heat transfer rate between the coolant channel and the battery pack in real-time, wherein one or more coolant channel side hydrodynamic conditions change with time due to variable coolant flow rates, wherein determining the heat transfer rate between the coolant channel and the battery pack comprises:

determining a lumped conductance data of the battery pack, for different predefined heat transfer coefficient values of the coolant channel, using a computational fluid dynamics (CFD) technique;
collecting a preliminary temperature distribution across the battery pack, from the pre-processed data, based on the initial temperature of the battery pack;
determining a current heat transfer coefficient value of the coolant channel, based on (i) a current coolant flow rate of the coolant channel, and (ii) a distance between each coolant channel battery intersection and the inlet of the coolant channel, for each of one or more coolant battery intersections;
determining a current lumped conductance data of each battery of the one or more batteries present in the battery pack, based on the current heat transfer coefficient value of the coolant channel associated to each coolant channel battery intersection, from the lumped conductance data of the battery pack; and
determining the heat transfer rate between the coolant channel and the battery pack in the real-time, based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack.

8. The one or more non-transitory machine-readable information storage mediums as claimed in claim 7, further comprising predicting a current temperature distribution inside the battery pack, based on the heat transfer rate between the coolant channel and the battery pack, using the variable coolant flow rate data of the coolant channel.

9. The one or more non-transitory machine-readable information storage mediums as claimed in claim 7, wherein determining the lumped conductance data of the battery pack, for different predefined heat transfer coefficient values of the coolant channel, using the computational fluid dynamics (CFD) technique, comprising:

receiving one or more dimensions of each battery of the one or more batteries of the battery pack, and one or more dimensions of the elastomer assembly attached to each battery;
receiving one or more thermal parameters comprising: (i) a tangential thermal conductivity and a radial thermal conductivity of each battery, (ii) a thermal conductivity of the elastomer assembly attached to each battery, (iii) a specific heat capacity of each battery and the associated elastomer assembly, and (iv) a density of each battery and the associated elastomer assembly;
creating a mesh of each battery of the one or more batteries and the mesh of the elastomer assembly attached to each battery, based on a geometry of each battery and the elastomer assembly attached to each battery, using a computer engineering software, wherein the geometry of each battery and the elastomer assembly attached to each battery is created using the one or more thermal parameters, and one or more dimensions of each battery of the one or more batteries of the battery pack, and one or more dimensions of the elastomer assembly; and
determining the lumped conductance data of the battery pack, for different predefined heat transfer coefficient values of the coolant channel, for different heat generation rates, by assigning one or more boundary conditions and running several test cases on the mesh of each battery of the one or more batteries and the mesh of the elastomer assembly attached to each battery, using the computational fluid dynamics (CFD) technique.

System **100**

**108**

Memory **102**

Modules **102a**

Repository **102b**

I/O interface(s) **106**

Hardware processor(s) **104**

FIG. 1

200

Obtain a plurality of battery data as an input, wherein the plurality of battery data comprises a temperature at one or more predefined locations of a battery pack comprising one or more batteries surrounding with an elastomer assembly, an initial temperature of the battery pack, a variable coolant flow rate data of a coolant channel present beside the battery pack, an inlet temperature of the coolant channel, load on an electric vehicle, and a current and a voltage of each battery of the one or more batteries of the battery pack, wherein the battery pack is deployed in the electric vehicle — 202

Preprocess the plurality of battery data to generate a pre-processed data, using one or more data pre-processing techniques — 204

Determine a heat transfer rate between the coolant channel and the battery pack in real-time, wherein one or more coolant channel side hydrodynamic conditions change with time due to variable coolant flow rates, wherein determining the heat transfer rate between the coolant channel and the battery pack comprises: — 206

Determining a lumped conductance data of the battery pack, for different predefined heat transfer coefficient values of the coolant channel, using a computational fluid dynamics (CFD) technique — 206a

Collecting a preliminary temperature distribution across the battery pack, from the pre-processed data, based on the initial temperature of the battery pack — 206b

Determining a current heat transfer coefficient value of the coolant channel, based on (i) a current coolant flow rate of the coolant channel, and (ii) a distance between each coolant channel battery intersection and the inlet of the coolant channel, for each of one or more coolant battery intersections — 206c

A

FIG. 2A

(A)

Determining a current lumped conductance data of each battery of the one or more batteries present in the battery pack, based on the current heat transfer coefficient value of the coolant channel associated to each coolant channel battery intersection, from the lumped conductance data of the battery pack — 206d

Determining the heat transfer rate between the coolant channel and the battery pack in the real-time, based on (i) the current heat transfer coefficient value of the coolant channel, (ii) the current lumped conductance data of each battery of the one or more batteries present in the battery pack, (iii) the preliminary temperature distribution, (iv) the inlet temperature of the coolant channel, (v) the load on the electric vehicle, and (vi) the current and the voltage of each battery of the one or more batteries of the battery pack — 206e

Predict a current temperature distribution inside the battery pack, based on the heat transfer rate between the coolant channel and the battery pack, using the variable coolant flow rate data of the coolant channel — 208

FIG. 2B

FIG. 3

FIG. 4

FIG. 5

| Receiving one or more dimensions of each battery of the one or more batteries of the battery pack, and one or more dimensions of the elastomer assembly attached to each battery | 206a1 |

| Receiving one or more thermal parameters comprising: (i) a tangential thermal conductivity and a radial thermal conductivity of each battery, (ii) a thermal conductivity of the elastomer assembly attached to each battery, (iii) a specific heat capacity of each battery and the associated elastomer assembly, and (iv) a density of each battery and the associated elastomer assembly | 206a2 |

| Creating a mesh of each battery of the one or more batteries and the mesh of the elastomer assembly attached to each battery, based on a geometry of each battery and the elastomer assembly attached to each battery, using a computer engineering software, wherein the geometry of each battery and the elastomer assembly attached to each battery is created using the one or more thermal parameters, and one or more dimensions of each battery of the one or more batteries of the battery pack, and one or more dimensions of the elastomer assembly | 206a3 |

| Determining the lumped conductance data of the battery pack, for different predefined heat transfer coefficient values of the coolant channel, for different heat generation rates, by assigning one or more boundary conditions and running several test cases on the mesh of each battery of the one or more batteries and the mesh of the elastomer assembly attached to each battery, using the computational fluid dynamics (CFD) technique | 206a4 |

FIG. 6

FIG. 7A

FIG. 7B

EP 4 549 235 A1

FIG. 8

FIG. 9

24

FIG. 10

FIG. 11

Europäisches
Patentamt

European
Patent Office

Office européen
des brevets

# EUROPEAN SEARCH REPORT

Application Number

EP 24 20 0293

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/149645 A1 (RAMANUJAM MURALIKRISHNAN [IN] ET AL) 12 May 2022 (2022-05-12) * paragraph [0002] - paragraph [0050] * ----- | 1-9 | INV. B60L58/24 B60L3/00 H01M10/48 H01M10/617 |
| Y | CN 101 013 765 A (UNIV TSINGHUA [CN]) 8 August 2007 (2007-08-08) * paragraph [0002] - paragraph [0023] * ----- | 1-9 | |

TECHNICAL FIELDS
SEARCHED       (IPC)

B60L
H01M
G06F

The present search report has been drawn up for all claims

| Place of search | Date of completion of the search | Examiner |
|---|---|---|
| The Hague | 25 February 2025 | Cuk, Vladimir |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.............................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 20 0293

25-02-2025

| Patent document cited in search report | Publication date | Patent family member(s) | | Publication date |
|---|---|---|---|---|
| US 2022149645 A1 | 12-05-2022 | EP<br>US | 3995346 A1<br>2022149645 A1 | 11-05-2022<br>12-05-2022 |
| CN 101013765 A | 08-08-2007 | NONE | | |

EPO FORM P0459

**EP 4 549 235 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202321075185